(19) **Europäisches Patentamt / European Patent Office / Office européen des brevets**

(11) **EP 1 872 956 A2**

(12) **EUROPEAN PATENT APPLICATION**

(43) Date of publication:
**02.01.2008 Bulletin 2008/01**

(51) Int Cl.:
**B41J 2/44** (2006.01)  **B41J 2/45** (2006.01)
**B41J 3/28** (2006.01)  **H05K 3/00** (2006.01)
**H05K 3/02** (2006.01)  **H05K 3/12** (2006.01)
**H05K 3/28** (2006.01)

(21) Application number: **07012463.1**

(22) Date of filing: **26.06.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **26.06.2006 US 816331 P**

(71) Applicant: **ORBOTECH LTD.**
**81102 Yavne (IL)**

(72) Inventors:
• **Ganot, Amnon**
  **Rishon Lezion, 75280 (IL)**
• **Hanina, Golan**
  **Rishon Lezion, 75381 (IL)**

(74) Representative: **Kuhnen & Wacker**
**Intellectual Property Law Firm**
**Prinz-Ludwig-Strasse 40A**
**85354 Freising (DE)**

(54) **Plotting an image on a thin material having variations in thickness**

(57)   System and corresponding method for plotting an image on a thin material having variations in thickness. System (40) includes: a plotter unit (46), for plotting the image on a surface (48) of thin material (42); a control unit (50), for controlling plotter unit (46), for effecting the plotting; and a thickness measuring device (52), for measuring thickness (44) of thin material (42). Control unit (50) receives measured thickness values from thickness measuring device (52), and uses measured thickness values for adjusting plotting of the image via plotter unit (46), to compensate for variations in thickness (44) of thin material (42).

Fig. 3

**Description**

FIELD AND BACKGROUND OF THE INVENTION

The present invention relates to techniques of automated plotting (writing, printing) of images on thin materials, and more particularly, to a system and method for plotting an image on a thin material having unpredictable variations or non-uniformities in thickness, via measuring thin material thickness, and adjusting the plotting as needed, to compensate for the thickness variations. The present invention is particularly applicable, but is not limited, to the fields of electronics, microelectronic and semiconductor manufacturing, requiring highly accurate and reproducible plotting (writing, printing) of images on films (as exemplary thin materials), which, for example, are usable as masks for fabricating printed circuit boards (PCBs). The present invention is also particularly applicable to the field of specialized graphic arts, for specialized applications requiring highly accurate and reproducible plotting (writing, printing) of images on thin materials (such as graphic arts writing or printing media).

Principles of thin materials (such as films), plotting (writing, printing) an image on a thin material, plotters (writers, printers) used for effecting such plotting, PCB masks made by plotting (writing, printing) images on films, and using PCB masks for fabricating printed circuit boards (PCBs), theories, and practices thereof, and, related and associated applications and subjects thereof, are well known and taught about in the prior art. For the purpose of establishing the scope, meaning, and fields or areas of application, of the present invention, the following background includes selected definitions and exemplary usages of terminology which are particularly relevant to, and used for, disclosing the present invention.

***Thin materials and films***

Herein, in the context of the field and art of the present invention, the phrase 'thin material' generally refers to a material whose thickness is significantly small in magnitude compared to one of its other dimensions. In general, the thickness of the thin material can be 'relatively small', for example, on the order of microns (or smaller), or alternatively, the thickness of the thin material can be 'relatively large', for example, on the order of meters (or larger), in order for the material to be considered a thin material as defined herein, and as being the work piece in the description of the present invention. In general, the thin material can be composed of essentially any single substance, or combination of substances, where a given substance consists of organic matter or/and inorganic matter.

An exemplary type of thin material is a film, being a (thin) strip or sheet of material whose thickness is significantly small in magnitude compared to one of its other dimensions. For example, fabricating a PCB typically involves using a PCB mask which is made from a thin material in the form of a film generally having a thickness within a range of between about 50 microns ($\mu$m) and about 500 microns ($\mu$m), and having a 'standard' thickness of about 180 microns ($\mu$m). As another example, a thin material (such as a film) used in specialized graphic arts has a 'standard' thickness of about 100 microns ($\mu$m). In general, a thin material need not have a thickness of on the order of microns

***Plotting (writing or printing) an image on a thin material***

Herein, plotting (writing or printing) an image on a thin material generally refers to generating, producing, forming, or creating, an image on a surface of a thin material (as defined hereinabove), ordinarily by using a mechanism, device or apparatus, such as a plotter, typically, included as part of an overall system, that effects the plotting (writing or printing). It is to be fully understood that the term 'plotting' is synonymous with the terms 'writing' and 'printing'. Moreover, it is to be fully understood that grammatical variants of the term 'plotting', such as 'plot', and 'plotter', are synonymous with corresponding grammatical variants of the term 'writing', such as 'write', and 'writer', respectively, and are synonymous with corresponding grammatical variants of the term 'printing', such as 'print', and 'printer', respectively. For purpose of clarity and consistency, the term 'plotting' is primarily used throughout the present specification. Accordingly, for example, the phrase 'plotting an image on a thin material', is synonymous with the corresponding phrases 'writing an image on a thin material' or 'printing an image on a thin material', and the phrase 'plotting head' is synonymous with the corresponding phrases 'writing head' or 'printing head' (which commonly appear in technical literature in the fields of electronic microelectronic and semiconductor manufacturing, particularly as relating to making PCB masks that are used for fabricating PCBs).

***Plotters and types thereof***

Herein, the term 'plotter' generally refers to a mechanism, device or apparatus, typically, included as part of an overall system, that is used for plotting an image on a thin material (as defined hereinabove). Two different general main types of a plotter are known as a drum plotter, and a flatbed plotter, which primarily differ according to the overall geometrical shape (drum, or flat, respectively) of a support element (herein, also referred to as a thin material support element) used for supporting and holding, and possibly moving, the thin material upon which the image is plotted. Moreover, two different general main types of a drum plotter are known as an external drum plotter, and an internal drum plotter, which primarily differ according to the location (external, or internal, respectively) of the thin material situated upon the support element, and according to location of operation of a plotting head relative to the support element during plotting of the image on the thin material.

An external drum plotter includes a drum whose *external* surface (as the thin material support element) functions for supporting and holding, and moving, the thin material upon which an image is plotted. The drum is controllably rotatable about its long axis (herein, referred to as the drum axis). An external drum plotter also includes a plotting head located and operative *external* to (outside of) the drum. The plotting head is connected to a plotting head moving mechanism which enables controllable movement of the plotting head along the drum axis. During operation, a thin material (such as a film), is positioned upon the external surface of the drum, the drum is made to rotate, and the plotting head moves and plots an image on the thin material.

An internal drum plotter includes a drum whose *internal* surface (as the thin material support element) functions for supporting and holding, and moving, the thin material upon which an image is plotted. The drum is either fixed, or is controllably rotatable about its long axis (the drum axis). An internal drum plotter also includes a plotting head located and operative *internal* to (inside of) the drum. The plotting head is connected to a plotting head moving mechanism which enables controllable movement of the plotting head along the drum axis and simultaneous rotation of the plotting head about its own axis. During operation, a thin material (such as a film), is positioned upon the internal surface of the drum, the drum is either fixed or made to rotate, and the plotting head moves, by traveling along the drum axis and rotating about its own axis, and plots an image on the thin material.

A flatbed plotter includes a *flat* (bed-type) surface (as the thin material support element) which functions for supporting and holding, and possibly moving, the thin material upon which an image is plotted. A flatbed plotter also includes a plotting head located and operative above the flat surface. The flat bed or/and the plotting head is/are connected to one or more moving mechanisms which enable controllable movement of the flat bed relative to the plotting head. During operation, a thin material (such as a film), is positioned upon the flat surface, the flat bed and the plotting head move relative to each other, and the plotting head plots an image on the thin material.

### *Photoplotters*

In general, any of the above stated general main types of a plotter (i.e., an external drum plotter, an internal drum plotter, or a flatbed plotter) whose structure and function (operation) are based on optics and use of a light source, and which plots an image on a thin material being a type of (light sensitive) photographic medium (such as photographic film), is considered a photoplotter (i.e., a mechanism, device, or apparatus, that *photo*plots an image via a photographic process). Thus, an external drum plotter, an internal drum plotter, or a flatbed plotter, whose structure and function are as just described are known as an external drum photoplotter, an internal drum photoplotter, and a flatbed photoplotter, respectively. Two different general main types of a photoplotter are known as a laser (or laser-based) photoplotter, and a light emitting diode or LED-based photoplotter, which primarily differ according to the specific type of light source (i.e., laser beam light, or diode light, respectively) used by the photoplotter for effecting the photographic process during *photo*plotting of an image on a thin material. As well as photo-plotting, the present invention is also applicable to electron beam, X-Ray, ink-jet and other kinds of non-photo plotting.

Photoplotters are widely used in the fields of electronics, microelectronic and semiconductor manufacturing, requiring highly accurate and reproducible plotting of images on films (as exemplary thin materials), which, for example, are usable as masks for fabricating printed circuit boards (PCBs). Photoplotters are also applicable to the field of specialized graphic arts, for specialized applications requiring highly accurate and reproducible plotting of images on thin materials (such as films).

### *Photoplotting for fabricating PCBs*

As is well known from prior art teachings (e.g., "Printed Circuit Board Basics", Third edition, by Michael flat, Miller Freeman Books, ISBN 0-89730-486-3, 1997, briefly, and in general, a PCB consists of a substrate that includes at least one conductive layer and at least one insulating layer. Fabricating a PCB includes producing tracks in the conductive layer in order to provide electrical interconnections between electronic components which are then added to the board at a later stage. Following computer aided design (CAD) of the electronics and of a PCB, and computer aided manufacture (CAM) of board substrates, final artwork chosen for producing the tracks is converted into a raster (digital) image and sent to a plotter (typically, a photoplotter). The photoplotter plots a black-and-white image on a film, which is then used as a PCB mask during processes for forming a desired pattern on the PCB.

***Significant problem associated with plotting an image on a thin material having variations in thickness***

Regardless of the field of application, but particularly in the fields of electronics, microelectronic and semiconductor manufacturing, and specialized graphic arts, requiring highly accurate and reproducible plotting of images on thin materials (such as on films, or on graphic arts writing or printing media), a significant problem arises when there is need for plotting of an image on a thin material having (unpredictable) variations or non-uniformities in thickness.

In general, one may consider at least three main categories of factors which affect accuracy and reproducibility of plotting an image on a thin material: (1) plotter mechanics, (2) plotter environment, and (3) thin material thickness.

Among several factors which may be considered in the category of plotter mechanics, there may exist structural (geometrical) imperfections, defects, or irregularities, in the plotter, particularly of the surface dimensions of the thin material support element (e.g., drum or flatbed, of a drum or flatbed plotter, respectively) used for supporting and holding, and possibly moving, the thin material upon which is plotted the image. Such structural effects can cause undesirable 'wobble' or deviations in the distance and relative movement particularly translational velocities, between the thin material support element, and therefore, between the thin material upon which the image is plotted, and a plotting head of a plotter which effects the actual plotting of the image on the surface of the thin material.

In the field of electronics, microelectronic and semiconductor manufacturing, for example, requiring highly accurate and reproducible photoplotting of images on films (as exemplary thin materials), which, for example, are usable as masks for fabricating printed circuit boards (PCBs), drum plotters, particularly external or internal drum photoplotters, are used to produce photo-tools for making PCB masks. These photo-tools require high dimensional accuracy when used as PCB masks, preferably below 10 microns ($\mu$m) (feature to feature - FTF or Feature to grid - FTG) for mask sizes exceeding 500 millimeters (mm). Drum photoplotters are highly sensitive to structural effects which can cause even minute variations in the height of the plotting surface of the film in relation to an axis around which the drum of the drum photoplotter rotates. Drum photoplotters are available (e.g., drum photoplotter models LP-7008™ and LP-9008™ from Orbotech Ltd., Israel) which make measurements of, and adjust plot timings (e.g., by adjusting a strobing frequency of an exposure beam), to compensate for, such structural (geometrical) imperfections, defects, or irregularities, in the drum photoplotter.

The category of plotter environment primarily relates to environmental factors, such as variations in temperature, pressure, or/and humidity, in the immediate or local environment surrounding or encompassing a plotter or/and a thin material during a plotting procedure, which may undesirably affect the characteristics of the plotter or/and of the thin material, during the plotting procedure.

The category of thin material thickness particularly relates to (unpredictable) variations or non-uniformities in the thickness of the thin material which typically exist under actual or real conditions of plotting an image on the surface of the thin material. Separate from, or in addition to, the preceding described structural effects, a given plotter may be highly sensitive to such variations in the thickness of the thin material, which can also cause undesirable deviations in the distance and relative movement (i.e., relative tangential or translational velocities) between the thin material support element, and therefore, between the thin material upon which the image is plotted, and a plotting head of the plotter which effects the actual plotting of the image on the surface of the thin material.

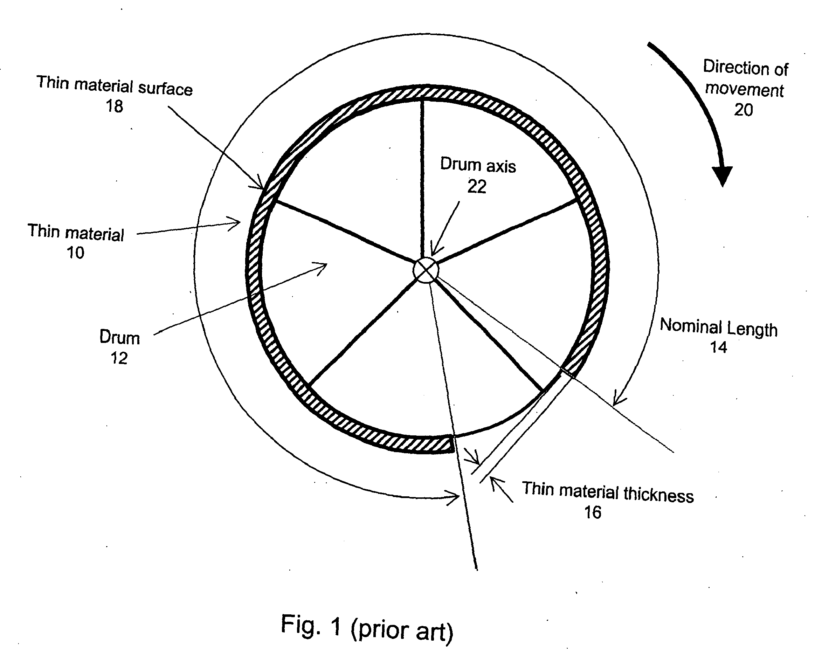

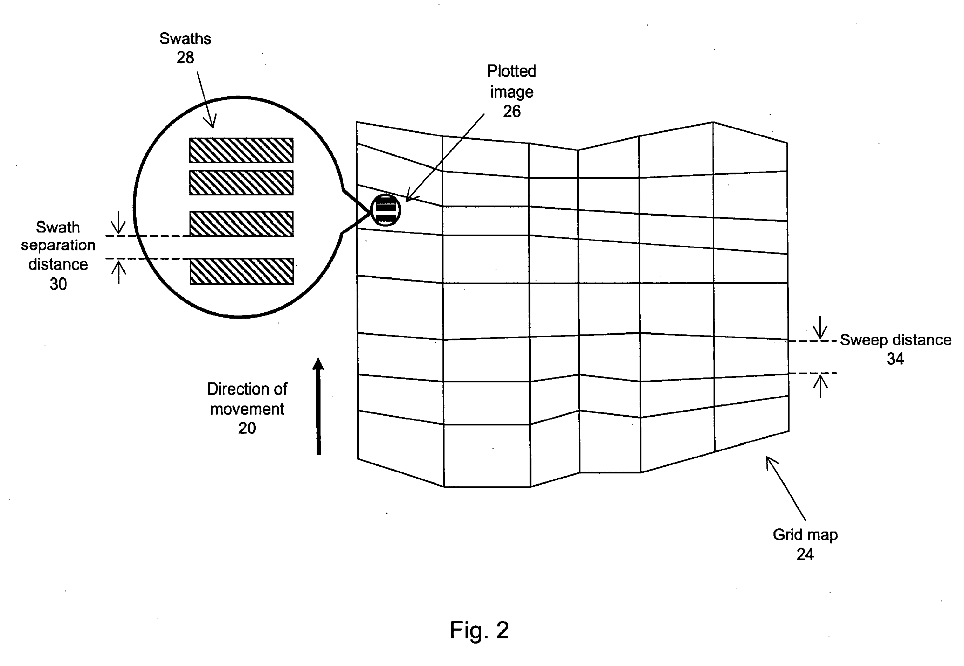

The present invention is focused on the third main category, particularly regarding those factors which are relevant to accurately and reproducibly plotting an image on a thin material having (unpredictable) variations or non-uniformities in the thickness of the thin material. An excellent way of further describing, and understanding, the preceding significant problem associated with plotting of an image on a thin material having (unpredictable) variations or non-uniformities in thickness, is provided in the following illustrative description, along with reference to Figs. 1 and 2.

Fig. 1 (prior art) is a schematic diagram illustrating a cross-section of thin material **10** positioned on the external surface of a drum **12** (for example, as part of an external drum plotter or photoplotter). Thin material **10** is characterized by a nominal length **14**, and by a thin material thickness **16**. Plotting of an image on thin material **10** is effected on thin material surface **18**, for example, by operation of an external drum plotter. Under *ideal* conditions, thin material **10** has constant thickness **16**. During operation of an external drum plotter, as drum **12** rotates (as indicated by direction of movement **20**) about drum axis **22** (to be understood as extending above, through, and below, the plane of Fig. 1) at a certain speed, the plotter, in which drum **10** is included, plots a desired image on surface **18** of thin material **10**.

However, under *real* conditions, a significant problem arises when thin material **10** has (unpredictable) variations or non-uniformities in thickness **16**. Magnitude of such variations in thickness **16** of thin material **10** may be extremely small, for example, as small as on the order of a few microns. Due to rotation of drum **12**, variations (even minute variations) in thin material thickness **16** of thin material **10** result in an *actual* tangential velocity of surface **18** that is different from an *expected* tangential velocity of surface **18**. Such behavior translates to a difference between an 'effective' nominal length and an 'ideal' nominal length **14** of thin material surface **18**, which, in turn, may affect one or more dimensions, or/and the contents (for example, plotted pixels being offset from a planned location), of an image plotted on thin material **10**.

Fig. 2 is a schematic diagram illustrating plotting location (via a grid map) resulting from changes in velocity of a thin material surface, for example, of thin material surface **18** of thin material **10** shown in Fig. 1, while plotting an image thereupon. Along with reference to Fig. 1, as shown in Fig. 2, grid map **24** of thin material surface **18** shows the location of a plotted image **26** on thin material surface **18**, for thin material surface **18** moving along direction of movement **20**. An exploded view of plotted image **26** shows that plotted image **26** is actually made of swaths (strips) **28**, separated from each other by an exemplary swath separation distance **30**. Swaths **28** are formed when a plotting head is in an active (plotting) mode, and swath separation distances **30** appear when the plotting head is in an inactive (plotting) mode. As shown by grid map **24**, a sweep distance **34** corresponds to the distance along thin material surface **18** swept by a plotting head within a selected amount of time.

Under *ideal* conditions, thin material **10** has a constant thickness **16** (Fig. 1), and therefore the tangential velocity of thin material surface **18** is constant throughout thin material surface **18** if the rotational velocity is given. In such a case, sweep distance **34** is also constant throughout thin material surface **18**, which means that a desired image can be plotted upon thin material surface **18**, having uniform swath separation distance **30**. Such behavior translates to a grid map of thin material surface **18** having grids with a constant sweep distance. However, under *real* conditions, thin material **10** has variations in thickness **16,** leading to variable translational or tangential velocity of thin material surface **18**, since the local radius is different, which causes variations in sweep distance **34**, as shown in grid map **24**. Variations in sweep distance **34** cause variations in swath separation distance **30** and misplacement of swaths **28**, resulting in plotted image **24** on thin material surface **18** of thin material **10** having one or more dimensions, or/and contents (for example, plotted pixels being offset from a planned location), being different from those of the desired plotted image.

Variation in thin material thickness can be found within a same piece of thin material, or among a plurality of pieces of thin material in a same batch or in different batches of the thin material. For a film type of thin material, magnitude of variations in thickness is typically on the order of microns, as shown in the following numerical example, which shows calculation of the limit in accuracy (in terms of plot dimension error) of a drum plotter upon which is supported or held a thin material (such as a film) having a variable thickness (due to tolerance).

The relationship between thin material thickness, which changes the surface height upon which an image or pattern is to be plotted, and plot dimension, respectively, as described above and shown in Figs. 1 and 2, may be generally described by the following equation:

$$Pde = \frac{FiLe}{DrCr} * (\Delta FiTh) \cdot 2 \cdot \pi \ ,$$

where:

    *Pde* = plot dimension error,
    *FiLe* = nominal thin material length (perpendicular or tangential to drum radius and along drum circumference),
    *DrCr* = drum circumference,
    *FiTh* = thin material thickness (for example, of a film), and
    *ΔFiTh* = delta (due to tolerance) in thin material thickness.

For example, for the following plotting conditions:

    drum circumference: 711,000 microns ($\mu$m) (28 inch drum),
    thin material thickness: 180$\mu$m (7 mil),
    thin material nominal length: 660,000 microns ($\mu$m) (26 inch thin material), and
    thin material thickness change (along the thin material or among batches):

        $\pm$ 3 microns ($\mu$m) (equal to 1.7 % tolerance),
    the deviation in plot dimension (plot dimension error) is:

$$Pde = \frac{660,000}{711,000} 2 \cdot \pi \cdot 3 = 17.5 \mu\mathrm{m} \ .$$

Therefore, according to the above plotting conditions, the accuracy of the drum plotter is limited to 17.5 microns ($\mu$m).

As described above, due to rotation of a drum in a drum plotter, variations (even minute variations on the order of a few microns) in thin material thickness of a thin material result in an *actual* translational velocity of the thin material surface that is different from an *expected* translational velocity of the thin material surface due to local changes in the radius. Such behavior translates to a difference between an 'effective' nominal length and an 'ideal' nominal length of the thin material surface, which, in turn, may affect one or more dimensions, or/and the contents (e.g., offset of pixels) of an image plotted on the thin material.

Although magnitude of variations in thickness of a film type of thin material can be as small as on the order of microns, in view of the preceding numerical example, even such minute variations can affect the tangential velocity of the film surface, which in turn may affect the dimension of an image plotted on the film when it is mounted on the external or interior surface (as the thin material support element) of a drum unit, as is typically used in plotter applications.

Presence of variations in thickness of a thin material may affect plotting of an image or images on the thin material, throughout the entirety of the thin material, or may be localized to one or more relatively small portions, or single locations, of the thin material. Moreover, variations in thin material thickness may exist within a same piece of thin material, or among a plurality of pieces of thin material in a same batch or in different batches of the thin material.

The significant problem of variations in thickness of a thin material undesirably affecting plotting of an image thereupon has been illustratively described and exemplified for a drum type plotter, used for plotting an image on a thin material having dimensions of a film. It is clearly understood that the problem is relevant to essentially any type of plotter (e.g., external or internal drum plotter, flatbed plotter, photoplotter) used for plotting an image on a thin material having non-film dimensions, where the plotting is characterized by distance and relative movement especially translational velocities between a thin material support element, and therefore, between the thin material upon which the image is plotted, and a plotting head of the plotter which effects the actual plotting of the image on the surface of the thin material.

There are extensive prior art teachings of techniques (methods, devices, apparatuses, systems) used for measuring thickness of various types or kinds of a material, as well as for measuring a distance between a material and another object. Selected examples of such teachings are provided hereinbelow.

U.S. Patent No. 5,485,082, to Wisspeinter et al., entitled: "Method Of Calibrating A Thickness Measuring Device And Device For Measuring Or Monitoring The Thickness Of Layers, Tapes, Foils, And The Like", provides a method for measuring thicknesses via a combination of eddy current sensors and inductive measuring scanners. Therein is also disclosed a method for calibrating such a thickness sensor. U.S. Patent No. 5,629,619, to Mednikov et al., entitled: "Noncontact Distance-measuring System Having At Least One Coil And Method Of Noncontact Distance Measuring Operating Either On The Basis Of Eddy Currents Or By Inductance", discloses a system and a method for measuring distances through eddy currents or by inductance. U.S. Patent Application Publication No. 2006-0202682, to Mednikov et al., entitled: "Non-contacting Position Measuring System", discloses a system for measuring the position of a material.

There are also prior art teachings of detecting, for example, by using a beam projecting device, and mechanically compensating for, irregularities in a drum surface of a drum plotter, for example, as disclosed in U.S. Patent No. 5,275,465, to Menard et al., entitled: "Plotter Drum", and in U.S. Patent No. 5,421,937, to Menard et al., entitled: "Methods Of Fabricating A Plotter Drum".

However, such prior art teachings are absent of providing any solution to the significant problem of variations in thickness of a thin material undesirably affecting plotting of an image thereupon.

There is thus a need for, and it would be useful to have a system and method for plotting an image on a thin material having (unpredictable) variations or non-uniforinities in thickness. Moreover, there is a need for such an invention which is particularly applicable, but not limited, to the fields of microelectronic and semiconductor manufacturing, requiring highly accurate and reproducible plotting (writing, printing) of images on films (as exemplary thin materials), which, for example, are usable as masks for fabricating printed circuit boards (PCBs). There is additionally a need for such an invention which is also particularly applicable to the field of specialized graphic arts, for specialized applications requiring highly accurate and reproducible plotting (writing, printing) of images on thin materials (such as graphic arts writing or printing media).

SUMMARY OF THE INVENTION

The present invention relates to techniques of automated plotting (writing, printing) of images on thin materials, and more particularly, to a system and method for plotting an image on a thin material having unpredictable variations or non-uniformities in thickness, via measuring thin material thickness, and adjusting the plotting as needed, to compensate for the thickness variations. The present invention is particularly applicable, but is not limited, to the fields of electronics, microelectronic and semiconductor manufacturing, requiring highly accurate and reproducible plotting (writing, printing) of images on films (as exemplary thin materials), which, for example, are usable as masks for fabricating printed circuit boards (PCBs). The present invention is also particularly applicable to the field of specialized graphic arts, for specialized applications requiring highly accurate and reproducible plotting (writing, printing) of images on thin materials (such as graphic arts writing, printing media or printing of X-ray images).

Thus, according to the present invention, there is provided a system for plotting an image on a thin material having variations in thickness, the system comprising: a plotter unit, suitable for plotting the image on a surface of the thin material; a control unit, suitable for controlling the plotter unit, for effecting the plotting; characterized in that the system further includes: a thickness measuring device, suitable for measuring thickness of the thin material, wherein the control unit is operative to receive measured thickness values from the thickness measuring device, and to use the measured thickness values for adjusting the plotting of the image via the plotter unit, to compensate for the variations in thickness of the thin material.

According to another aspect of the present invention, there is provided a method for plotting an image on a thin material having variations in thickness, the method comprising:

measuring thickness of the thin material,
generating measured thickness values of the thin material;
controlling a plotter unit, to effect said plotting; and
plotting the image on a surface of the thin material, said controlling comprising using said measured thickness values for adjusting said plotting of the image, to compensate for the variations in thickness of the thin material.

BRIEF DESCRIPTION OF THE DRAWINGS

The present invention is herein described, by way of example only, with reference to the accompanying drawings. With specific reference now to the drawings in detail, it is stressed that the particulars shown are by way of example and for purposes of illustrative description of the preferred embodiments of the present invention only, and are presented in the cause of providing what is believed to be the most useful and readily understood description of the principles and conceptual aspects of the present invention. In this regard, no attempt is made to show structural details of the present invention in more detail than is necessary for a fundamental understanding of the invention, the description taken with the drawings making apparent to those skilled in the art how the several forms of the invention may be embodied in practice. In the drawings:

Fig. 1 (prior art) is a schematic diagram illustrating a cross-section of a thin material positioned on the external surface of a drum (for example, as part of an external drum plotter);
Fig. 2 is a schematic diagram illustrating plotting location (via a grid map) resulting from changes in velocity of a thin material surface, for example, of the thin material surface of the thin material shown in Fig. 1, while plotting an image on the surface of the thin material;
Fig. 3 is a schematic diagram illustrating an exemplary generalized embodiment of a system for plotting an image on a thin material having variations in thickness, in accordance with the present invention;
Fig. 4 is a flow diagram of an exemplary generalized embodiment of a method for plotting an image on a thin material having variations in thickness, in accordance with the present invention;
Fig. 5 is a schematic diagram illustrating an exemplary specific embodiment of a system for plotting an image on a thin material having variations in thickness, wherein the plotter unit is a type of an external drum plotter, in accordance with the present invention;
Fig. 6 is a schematic diagram illustrating an exemplary specific embodiment of a system for plotting an image on a thin material having variations in thickness, wherein the plotter unit is a type of an internal drum plotter, in accordance with the present invention;
Fig. 7 is a schematic diagram illustrating an exemplary specific embodiment of a system for plotting an image on a thin material having variations in thickness, wherein the plotter unit is a type of a flatbed plotter, in accordance with the present invention;
Fig. 8 is a schematic diagram illustrating another exemplary embodiment of a system for plotting an image on a thin material having variations in thickness, focusing on the components of a plotter unit, for example, as part of the system illustrated in Figs. 3, 5, 6, or 7, in accordance with the present invention; and
Fig. 9 is a schematic diagram illustrating an exemplary detailed embodiment of the system illustrated in Fig. 8, particularly showing structure and function (operation) of a plotter unit (of Fig. 8) being a type of an external drum photoplotter, in accordance with the present invention.

DESCRIPTION OF THE PREFERRED EMBODIMENTS

The significant problem associated with plotting of an image on a thin material having unpredictable variations or non-uniformities in thickness, was illustratively described, and numerically exemplified, hereinabove, with reference to Figs. 1 and 2. As described above, for example, due to rotation of a drum in a drum plotter, variations (even minute variations on the order of a few microns) in thin material thickness of a thin material result in an *actual* translational velocity of the thin material surface that is different from an *expected* translational velocity of the thin material surface due to a local change in the radius. Such behavior translates to a difference between an 'effective' nominal length and an 'ideal' nominal length of the thin material surface, which, in turn, may affect one or more dimensions, or/and the contents (e.g., offset of pixels) of an image plotted on the thin material. Although magnitude of variations in thickness of a film type of thin material can be as small as on the order of microns, in view of the above numerical example, even such minute variations can affect the translational or tangential velocity of the film surface, which in turn may affect the dimension of an image plotted on the film when it is mounted on the external or interior surface (as the thin material support element) of a drum unit, as is typically used in plotter applications.

In the field of microelectronic and semiconductor manufacturing, for example, requiring highly accurate and reproducible photoplotting of images on films (as exemplary thin materials), which, for example, are usable as masks for fabricating printed circuit boards (PCBs), drum plotters, particularly external or internal drum photoplotters, are used to produce photo-tools for making PCB masks. These photo-tools require high dimensional accuracy when used as PCB masks, preferably below 10 microns ($\mu$m) for mask sizes exceeding 500 millimeters (mm).

The present embodiments relate to techniques of automated plotting (writing, printing) of images on thin materials, and more particularly, to a system and method for plotting an image on a thin material having (unpredictable) variations or non-uniformities in thickness, via measuring thin material thickness, and adjusting the plotting as needed, to compensate for the thickness variations. The present embodiments are particularly applicable, but are not limited, to the fields of microelectronic and semiconductor manufacturing, requiring highly accurate and reproducible plotting (writing, printing) of images on films (as exemplary thin materials), which, for example, are usable as masks for fabricating printed circuit boards (PCBs). The present embodiments are also particularly applicable to the field of specialized graphic arts, for specialized applications requiring highly accurate and reproducible plotting (writing, printing) of images on thin materials (such as graphic arts writing or printing media).

An exemplary generalized embodiment of a system for plotting an image on a thin material having variations in thickness, includes the following main components and functionalities thereof: a plotter unit, for plotting the image on a surface of the thin material; a control unit, for controlling the plotter unit, for effecting the plotting; and a thickness measuring device, for measuring thickness of the thin material. In the exemplary generalized embodiment of the system, the control unit receives measured thickness values from the thickness measuring device, and uses the measured thickness values for adjusting the plotting of the image via the plotter unit, to compensate for the variations in thickness of the thin material.

An exemplary generalized embodiment of a method for plotting an image on a thin material having variations in thickness, includes the following main steps or procedures, and, components and functionalities thereof: plotting the image on a surface of the thin material, by a plotter unit; controlling the plotter unit, for effecting the plotting; measuring thickness of the thin material, for generating measured thickness values of the thin material; and using the measured thickness values for adjusting the plotting of the image, to compensate for the variations in thickness of the thin material.

Generalized and specific embodiments of a system and method for plotting an image on a thin material having variations in thickness, according to the present invention, are better understood with reference to the following illustrative description and accompanying drawings. Throughout the following illustrative description and accompanying drawings, same reference notation and terminology (i.e., numbers, letters, or/and symbols), refer to same components, elements, or/and parameters.

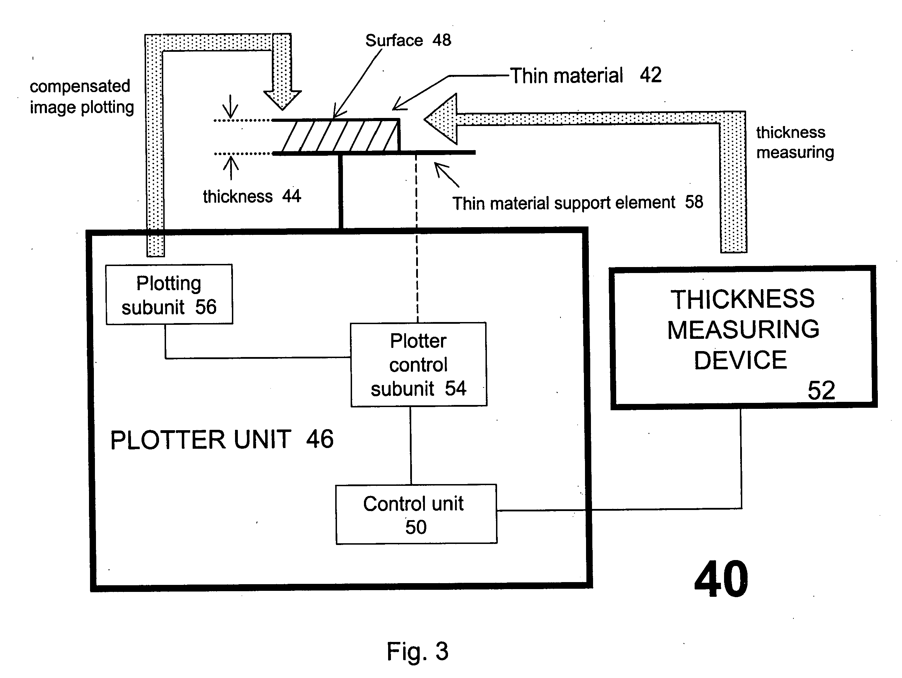

Referring now to the drawings, Fig. 3 is a schematic diagram illustrating an exemplary generalized embodiment of a system, herein, referred to as system **40**, for plotting an image on a thin material **42** having variations in thickness **44**. As shown in Fig. 3, system **40** includes the following main components and functionalities thereof: a plotter unit **46**, for plotting the image on a surface **48** of thin material **42**; a control unit **50**, for controlling plotter unit **46**, for effecting the plotting; and a thickness measuring device **52**, for measuring thickness **44** of thin material **42**. In the exemplary generalized embodiment of system **40**, control unit **50** receives measured thickness values from thickness measuring device **52**, and uses the measured thickness values for adjusting the plotting of the image via plotter unit **46**, to compensate for the variations in thickness **44** of thin material **42.**

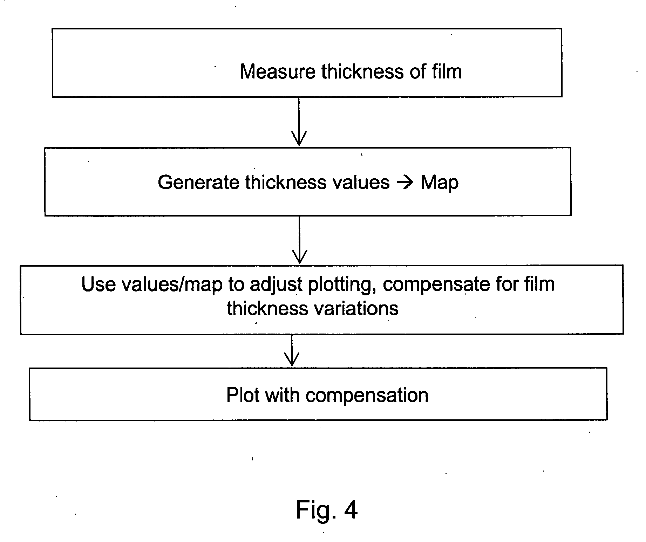

Fig. 4 is a flow diagram of an exemplary generalized embodiment of a method, for plotting an image on a thin material having variations in thickness. As shown in Fig. 4, along with reference to system **40** shown in Fig. 3, the method includes the following main steps or procedures, and, components and functionalities thereof : (a) Measure the thickness 44 of thin material 42; (b) Generating thickness values of the thin material 42 and creating a map of thickness values; (c) using the measured thickness values for adjusting the plotting of the image, to compensate for the variations in thickness **44** of the thin material **42; (d)** plotting (with compensation) the image on a surface **48** of the thin material **42**, by a plotter unit **46**

As shown in Fig. 3 (of the system), along with reference to Fig. 4 (of the corresponding method), in system **40**, plotter unit **46** includes a plotter control subunit **54**, a plotting subunit **56**, and a thin material support element **58**, upon which thin material **42** is positioned. Thickness measuring device **52** measures a thickness at surface **48** of thin material **42**, and sends the resulting thickness measurement to control unit **50**. Control unit **50** receives the thickness measurement and adjusts one or more plotting parameters according to pre-programmed algorithms. Adjustment data of the plotting parameters from control unit **50** are received by plotter unit **46** and sent to plotter control subunit **54** for processing, for compensating for the variations in thickness **44** of thin material **42**. Plotter control subunit **54** then sends the processed data to plotting subunit **56**, which includes a plotting head, which then plots an image on surface **48** of thin material **42**.

### *Plotter Unit*

The plotter unit **46** includes a thin material support element **58**, for supporting thin material **42** and plotting subunit **56**, which can move relative to each other. Plotter unit **46** also includes a plotter control subunit **54**, which regulates the relative movement between thin material support element **58** and plotting subunit **56**, as well as the timing in the plotting of plotting subunit **56**. Plotter unit **46** further includes control unit **50**, which calculates compensation parameters according to input data sent to control unit **50**, which, in turn, is sent to plotter control subunit **54**. Exemplary types of plotter units commonly used in PCB mask production, are drum photoplotters, which are readily commercially available (e.g., drum photoplotter models LP-7008™ and LP-9008™ from Orbotech Ltd., Israel).

### *Thin Material Support Element*

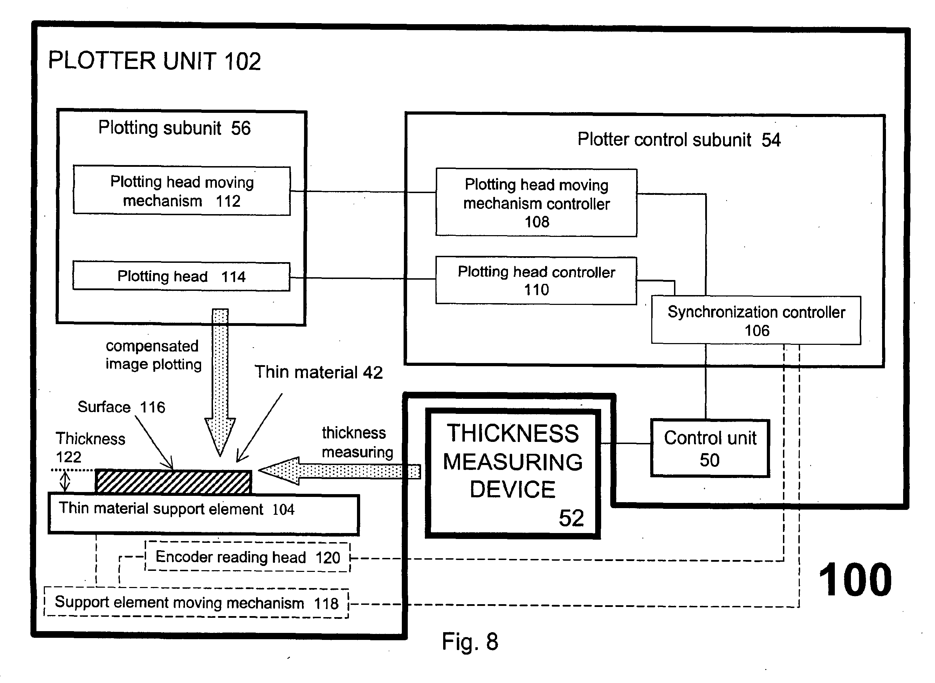

The thin material support element **58** is for supporting and holding, and possibly moving, thin material **42** upon which an image is plotted. Thin material support element **58** may be fixed or movable. For example, as shown in Fig. 8, hereinbelow, if thin material support element **104** is movable, then thin material support element **104** is controllably movable by a support element moving mechanism **118**. In such an embodiment, signals of movement of support element moving mechanism **118** are sent to an encoder reading head **120**, which sends out signals to synchronization controller **106** indicating the position of thin material support element **104**. Encoder reading head **120** sends data to plotter control subunit **54**, whereby support element moving mechanism **118** is controllable by synchronization controller **106**. Thin material support element **104** can be, for example, the outer surface of a drum roller of an external drum plotter, the inner surface of a drum roller of an internal drum plotter, or a flat surface of a flatbed plotter.

### *Plotter Control Subunit*

The plotter control subunit **54** regulates the relative movement between thin material support element **58** and plotting subunit **56,** of plotter unit **46,** as well as the speed and timing in the plotting by plotting subunit **56**. In some plotters for PCB photo-tool manufacture, inaccuracies in geometric dimensions of the drum (the thin material support element) and wobble, resulting in velocity changes of the drum surface, are measured and plot timings are adjusted, for example by adjusting a strobing frequency of an exposure beam, to compensate for these inaccuracies. This compensation mechanism can be enhanced according to the presently preferred embodiments to further compensate for the variations in thickness **44** of thin material **42**, also resulting in velocity changes of surface **48** upon which an image or pattern is plotted, for example by further adjusting plot timings on-the-fly (i.e., during real time operation of plotter unit **46**.

### *Plotting Subunit*

Operations of plotting subunit **56** are controlled by plotter control subunit **54**. In the exemplary specific embodiment of the present invention shown in Fig. 8, plotting subunit **56** includes a plotting head moving mechanism **112**, which provides for movement of plotter subunit **56,** and a plotting head **114**, whereby plotting head **114** directly plots an image on surface **116** of thin material **42**. Examples of plotting head **114** are lasers or diodes, emitting specific wavelengths of light.

### *Thickness Measuring Device*

The thickness measuring device **52** preferably operates according to a non-contacting, measuring process. Thickness measuring device **52** may comprise: an optical sensor using a suitable optical measurement method, such as a triangulation method, or an interferometry method; a mechanical sensor using a suitable mechanical probe; a capacitor based sensor to make a measurement based on dielectric characteristics of thin material **42**; or any other type of sensor, such as, but not limited to, x-ray based, ultrasound based, and depth of focus based, sensors. Thickness measuring device **52** may be positioned as follows: externally, to measure thickness **44** of thin material **42** before or prior to loading onto plotter unit **46**, or, alternatively, embedded inside plotter unit **46**.
Thin material thickness measurements carried out by thickness measuring device **52** include, but are not limited to, online sampling of thickness **44** of thin material **42** during the plotting process, and offline generation of a three-dimensional grid map of thin material **42** before the plotting process. Thickness measurements may be carried out either on a batch basis, or for each individual sheet of thin material before the image plotting, or in accordance with a suitable periodic quality control sampling schedule.

For implementing the present invention, an exemplary suitable thickness measuring device **52** is the Combisensor™, available from Micro-Epsilon corporation of Ortenburg, Germany.

## *Control unit*

Control unit **50** includes computing subunits that receive thickness measurements from thickness measuring device **52** and adjust at least one plotting parameter, according to pre-programmed algorithms. Control unit **50** processes data transmitted to it, both online (i.e., real time, during a plotting process) and offline (i.e., before or prior to a plotting process), depending on the specific mode of operation of thickness measuring device **52**, as described above.

In exemplary specific embodiments of the present invention, the system, and method, are optimized for plotting on a film. The film can be photosensitive. A non-limiting example of photosensitive film is silver-halide film. A non-limiting example of photosensitive silver-halide film is the Kodak ACCUMAX™ film family, which offers sensitivities to light of wavelengths of 488 nm (from Argon-Ion laser), 532, 543, 565, 633 nm (from Helium-Neon laser), and 670 nm (from red laser diodes).

In additional exemplary specific embodiments of the present invention, the plotter unit is a photoplotter. The plotting subunit of the photoplotter can be based on, but not limited to, LEDs or lasers.

In additional exemplary specific embodiments of the present invention, the plotter unit includes a thin material support surface corresponding to an external drum, or an internal drum, or a flatbed.

In additional exemplary specific embodiments of the present invention, the thickness measuring device is included within, or part of, the plotter unit.

In additional exemplary specific embodiments of the present invention, the thickness measuring device is located outside of, or external to, the plotter unit, and includes a map generator, for generating three-dimensional maps of the, thin material thickness variation as a function of (x, y) position or location of the thin material, before the thin material is inserted into the plotter. Though this embodiment may lead to slower plotting, it can increase accuracy of the plotting of the image on the surface of the thin material.

In additional exemplary specific embodiments of the present invention, the thickness measuring device includes one or more of the following features: an optical sensor, to determine the thickness of the thin material, a mechanical probe to determine the thickness of the thin material, and a capacitor-based sensor to measure at least one dielectric characteristic of the thin material and to compute therefrom at least one thickness value of the thin material.

In additional exemplary specific embodiments of the present invention, the plotting parameter to be adjusted to compensate for the thickness, may be one or more of the following parameters: a plotter scaling factor, a plotter timing factor, and an image size parameter.

The *plotter scaling factor* is a set of parameters that defines the scaling between the original image dimension and the plotted image dimension. The *plotter timing factor* is based on: (i) the velocity of the thin material support element, or/and (ii) the velocity of the plotting head moving mechanism, or/and (iii) the plotting speed or/and plotting timing. The *image size parameter* is a set of numerical data that corresponds to the physical size of the plotted image.

In additional exemplary specific embodiments of the present invention, the measuring step of the above method includes generating a plurality of thickness values for each of a plurality of thin material sheets on a per-sheet basis.

In additional exemplary specific embodiments of the present invention, the measuring step includes generating at least one thickness value for each of a plurality of thin material batches on a per-batch basis.

The present embodiments thus provide a combination of a plotter unit, including a control unit, and a thickness measuring device, which allows compensation for the variable thickness of the thin material. Compensation may be performed in two ways: real-time and off-line. In the off-line compensation mode, the thickness of the thin material is measured before the thin material is fed into the plotter unit, and correction tables are calculated offline for subsequent use in the plotting. In the real-time compensation mode, the thickness of the thin material is measured and compensated for, while the thin material is in the plotter unit and being plotted upon.

Use of the above embodiments may provide a relatively improved level of accuracy in the plot, due to the compensation for the variable thickness of the thin material plotted upon.

One feature of the present embodiments is the short amount of time that passes between the thickness measurement and the plotting after compensation, allowing for 'on-the-fly' dynamic compensation. More specifically, the compensation process may be fast enough not to cause deterioration in performance (in terms of throughput) of the plotter unit.

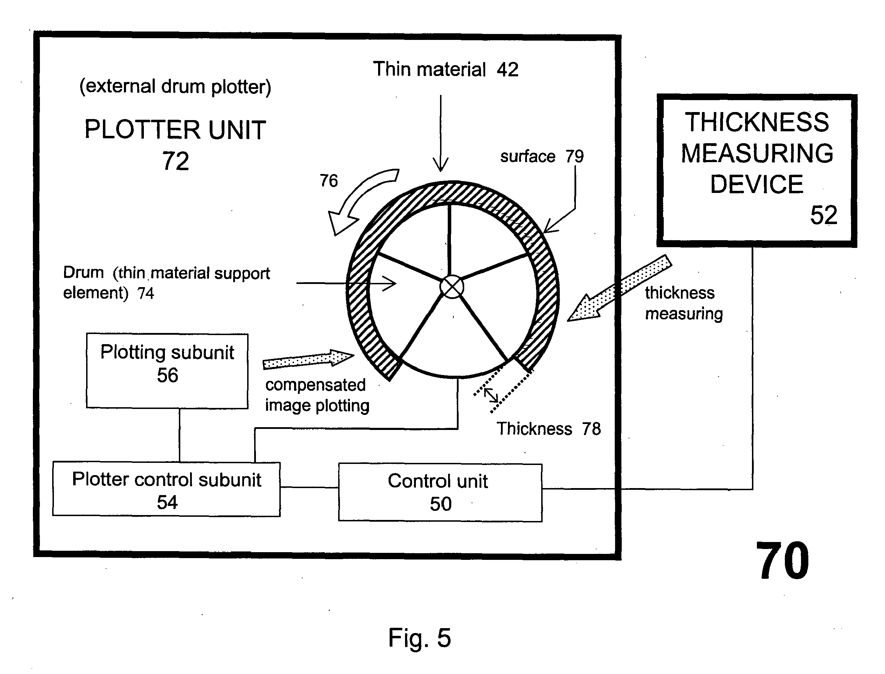

Fig. 5 is a schematic diagram illustrating an exemplary specific preferred embodiment of system **40** illustrated in Fig. 3, herein, in Fig. 5 referred to as system **70**, for plotting an image on a thin material **42** having variations in thickness **78**, wherein plotter unit **72** is an external drum plotter. As shown in Fig. 5, plotter unit **72** is an external drum plotter. Plotter unit **72** includes a plotter control subunit **54**, a plotting subunit **56**, and a drum **74**. Drum **74** corresponds to the thin material support element which can rotate around its axis (in Fig. 5, indicated by **76**). Thin material **42** is positioned on the outer surface of drum **74**. Thickness measuring device **52** measures thickness **78** of thin material **42** at surface **79** of thin material **42**, and sends thickness measurements to control unit **50**.

Control unit **50** receives the thickness measurements and adjusts one or more plotting parameters according to pre-programmed algorithms. Adjustment data of the parameters sent from control unit **50** are received by plotter control subunit **54**, which adjusts the plotting according to the adjusted parameters, through its connections to drum **74** and plotting subunit **56**. Plotting subunit **56** plots an image on surface **79** of thin material **42**, according to the instructions plotting subunit **56** receives from plotter control subunit **54**.

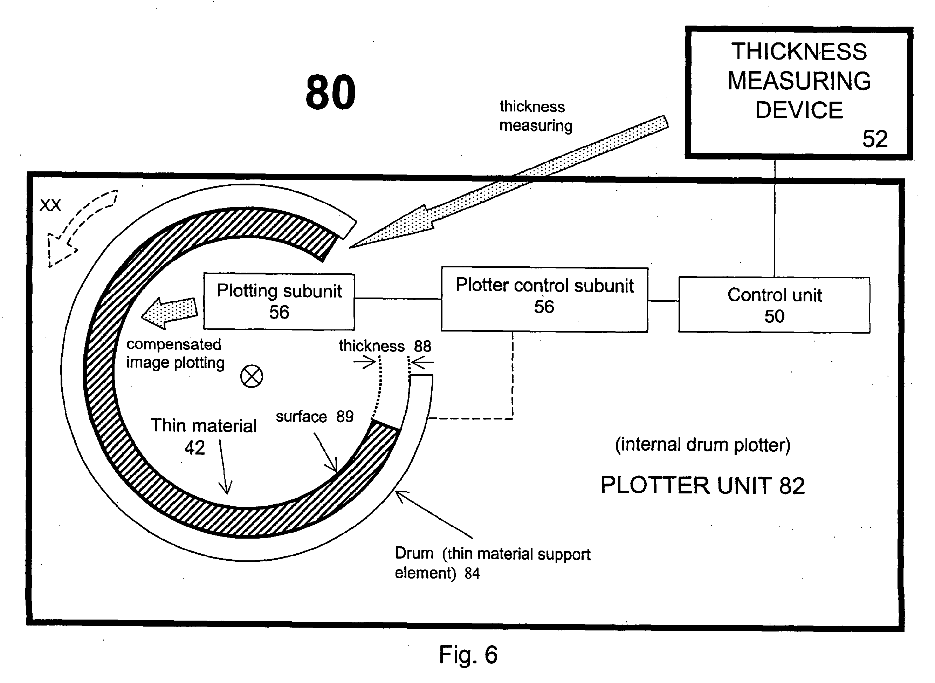

Fig. 6 is a schematic diagram illustrating another exemplary specific preferred embodiment of system **40** illustrated in Fig. 3, herein, in Fig. 6 referred to as system **80**, for plotting an image on a thin material **42** having variations in thickness **88**, wherein plotter unit **82** is an internal drum plotter. Plotter unit **82** includes a plotter control subunit **54**, a plotting subunit **56**, and a drum **84**. Drum **84** corresponds to the thin material support element, which is usually fixed and unable to rotate or translate. In specific embodiments, drum **84** may rotate around its axis (in Fig. 6, indicated by **86**). Thin material **42** is positioned on the inner surface of drum **84**. Thickness measuring device **52** measures thickness **88** of thin material **b**2, and sends thickness measurements to control unit **50**.

Control unit 50 receives the thickness measurements and adjusts one or more plotting parameters according to pre-programmed algorithms. Adjustment data of the parameters sent from control unit **50** are received by plotter control subunit **54**, which adjusts the plotting according to the adjusted parameters, through its connections to plotting subunit **56**. Plotting subunit **56** plots an image on surface **89** of thin material **42**, according to the instructions plotting subunit **56** receives from plotter control subunit **54**. If drum **84** is able to rotate, plotter control subunit **54** is also connected to drum **84** (in Fig. 6, indicated by the dashed line between plotter control subunit **54** and drum **84**).

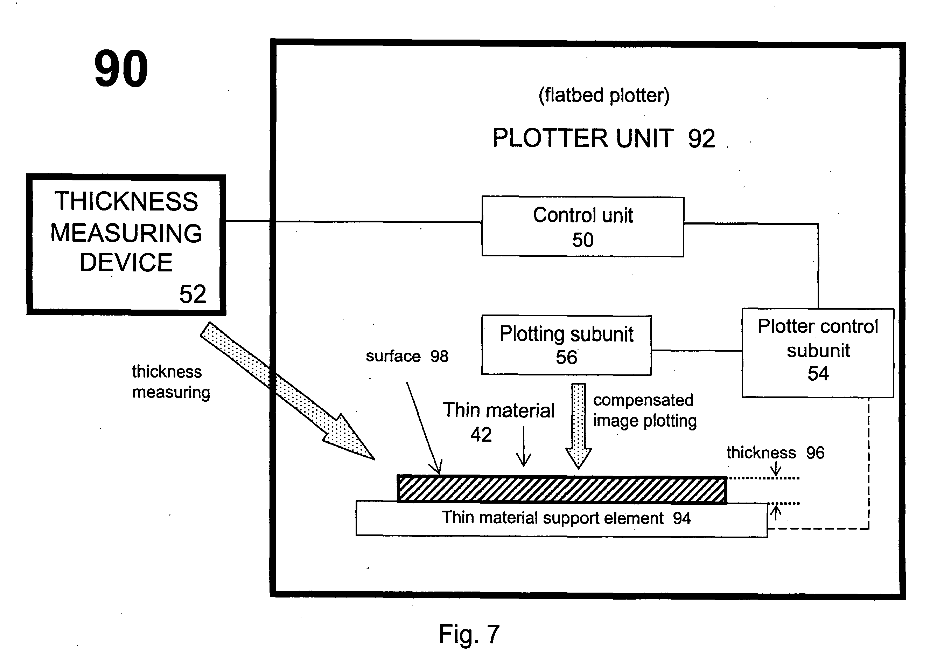

Fig. 7 is a schematic diagram illustrating another exemplary specific preferred embodiment of system **40** illustrated in Fig. 3, herein, in Fig. 7 referred to as system **90**, for plotting an image on thin material **42** having variations in thickness **96**, wherein plotter unit **92** is a flatbed type of plotter. Plotter unit **92** includes a plotter control subunit **54**, a plotting subunit **56**, and a flat thin material support element **94**. Thin material support element **94** may be fixed or is controllably movable. Thin material **42** is positioned on the surface of thin material support element **94**. Thickness measuring device **52** measures thickness **96** at surface **98** of thin material **42**, and sends thickness measurements to control unit **50**.

Control unit **50** receives the thickness measurements and adjusts one or more plotting parameters according to pre-programmed algorithms. The adjusted parameters may be, but are not limited to, plotting speed and/or timing, plotting head movement, and thin material support element speed.

In the case of a fixed thin material support element **94,** adjustment data from control unit **50** is received by plotter control subunit **54**, which performs the adjustments via its connection to plotting subunit **56**. Plotting subunit **56** plots an image on surface **98** of thin material **42**, according to the instructions it receives from plotter control subunit **54**.

In the case of a movable thin material support element **94**, plotter control subunit **54** is also connected to thin material support element **94** (in Fig. 7, indicated by the dashed line between plotter control subunit **54** and thin material support element **94**). Plotter control subunit **54** can therefore perform further adjustments to thin material support element **94**, by regulating movement of thin material support element **94**.

Fig. 8 is a schematic diagram illustrating another exemplary embodiment of a system, herein, in Fig. 8 referred to as system **100**, for plotting an image on a thin material **42** having variations in thickness **122**, focusing on the components of a plotter unit **102**, for example, as part of any of the systems **40**, **70**, **80**, or **90**, illustrated in Figs. 3, 5 (external drum plotter), 6 (internal drum plotter), or 7 (flatbed plotter). Fig. 8 particularly shows integrated layout and operation of thin material **42**, a thin material support element **104**, control unit **50**, plotter control subunit **54**, plotting subunit **56**, and thickness measuring device **52**. Plotter control subunit **54** includes a synchronization controller **106**, a plotting head moving mechanism controller **108**, and a plotting-head controller **110**. Plotting subunit **56** includes a plotting head moving mechanism **112**, which provides for movement of plotter subunit **56**, and a plotting head **114**, whereby plotting head **114** directly plots an image on surface **116** of thin material **42.**

Thin material support element **104** can be, for example, the outer surface of a drum roller of an external drum plotter, the inner surface of a drum roller of an internal drum plotter, or a flat surface of a flatbed plotter. Thin material support element **104** may be fixed or movable. For example, as shown in Fig. 8, if thin material support element **104** is movable, then thin material support element **104** is controllably movable by a support element moving mechanism **118**. In such an embodiment, signals of movement of support element moving mechanism **118** are sent to an encoder reading head **120**, which sends out signals to synchronization controller **106** indicating the position of thin material support element **114**. Encoder reading head **120** sends data to plotter control subunit **54**, whereby support element moving mechanism **118** is controllable by synchronization controller **106.**

Following measuring thickness **122** of thin material **42** by thickness measuring device **52**, and computation of compensation parameters by control unit **50**, synchronization controller **106** receives the compensation parameters from control unit **50.** If thin material support element **104** is movable, then synchronization controller **106** controls movement of thin material support element **104**, via its connection to support element moving mechanism **118.** Synchronization controller **106** further verifies the position of thin material support element **104**, by receiving the signal transmitted by encoder reading head **120.** Plotting head moving mechanism controller **108** controls movement of plotting head moving mechanism **112**. Plotting head controller **110** controls plotting speed and timing of plotting head **114**. Synchronization controller **106** also regulates the timing for conveying instructions from plotting head moving mechanism controller **108** to plotting head moving mechanism **112** and from plotting head controller **110** to plotting head **114.**

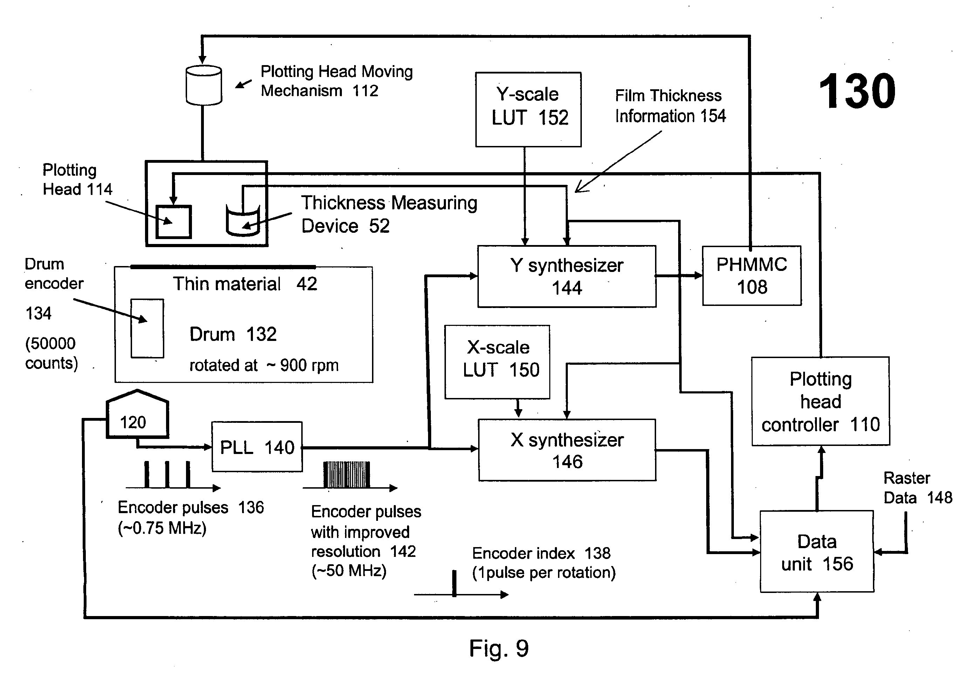

Fig. 9 is a schematic diagram illustrating an exemplary detailed embodiment, herein, in Fig. 9 referred to as embodiment **130**, of the system **100** illustrated in Fig. 8, particularly showing structure and function (operation) of plotter unit **102** (of Fig. 8) being a type of an external drum photoplotter. In Fig. 9, embodiment **130** includes a rotating drum **132**, for example, of an external type drum photoplotter, where drum **132** rotates at an exemplary rotational speed of about 900 rounds per minute (rpm). Embodiment **130** also includes a thickness measuring device **52** included in, as part of, plotting subunit **56** (Fig. 8). Embodiment **130** also includes a drum encoder **134** which sends signals to encoder reading head **120**, which monitors rotation of drum **132**. Encoder reading head **120** generates encoder pulses **136** and encoder index pulses **138**, according to tangential speed of drum **132**.

Encoder pulses **136** are sent to a Phased Locked Loop Mechanism (PLL) **140**, which generates pulses **142** with improved resolution (typically 50 MHz). Typical encoder pulse **136** frequency is 0.75 MHz, depending upon rotation speed and number of encoder counts. PLL output pulses **142** are sent to a Y-synthesizer **144** and to an X-synthesizer **146.** Y-synthesizer **144** regulates operation of plotting head movement mechanism **112,** via a plotting head moving mechanism controller (PHMMC) **108**. X-synthesizer **146** regulates timing of the turning ON and OFF of plotting head **114** in accordance with raster data **148**. Encoder reading head **120** generates an encoder index pulse **138** that serves two purposes: (1) for setting reference points for the starting positions of image slice plotting; and (2) for verifying that drum **132** is in the right position. X-synthesizer **146** and Y-synthesizer **144** generate output signals whose frequencies are determined by X-scale calibration look-up tables (LUT) **150** and Y-scale calibration look-up tables (LUT) **152,** respectively.

Such look-up tables are prepared in advance during plotter calibration by measuring constant (repeatable) geometrical distortions (determined by environmental and mechanical factors, as described hereinabove in the Background section). Thickness measuring device **52**, which is mounted on the same plotting head moving mechanism **112** as plotting head **114,** sends thin material thickness measurement data and information **154** to X-synthesizer **146,** Y-synthesizer **144,** and data unit **156**. Film thickness information **154** is used for generating additional adjustment type corrections in the timing of plotting head movement mechanism **112** and timing of the turning ON and OFF of plotting head **114**, in accordance with the thickness of thin material **42** at a particular location along thin material **42**.

Thin material thickness measurements can be performed in advance, before the plotting (including the option to perform thickness measurements outside the plotter, i.e., 'offline'), or, alternatively, 'on the fly' during real time plotting of the image on thin material **42**. For an 'on-the-fly' (real time) embodiment, thickness measuring device **52** measures thickness of thin material **42** a short time prior to plotting head **114** plots an image on the surface of thin material **42**. Such synchronization provides for the time required for the signals of film thickness information **154** to be processed by Y-synthesizer **144**, X-synthesizer **146**, and data unit **156**, and time for the output signal from Y-synthesizer **144** to be received, via plotting head moving mechanism controller (PHMMC) **108**, by plotting head movement mechanism **112**. Such synchronization also provides for the time required for the output signal from X-synthesizer **146** to be received, via data unit **156** and plotting head moving mechanism controller (PHMMC) **108**, by plotting head **114**. Based on the just described 'compensation' signals received by plotting head **114**, then, plotting head **114** effects the plotting of the image on thin material **42**.

The components of embodiment **130** of Fig. 9 can be mapped onto the corresponding components of system **100** of Fig. 8, as follows. X-scale LUT **150,** Y-scale LUT **152,** and data unit **156** are part of control unit **50**. Y-synthesizer **144** and X-synthesizer **146** are elements shared between control unit **50** and synchronization controller **106.**

It is appreciated that certain aspects and characteristics of the invention, which are, for clarity, described in the context of separate embodiments, may also be provided in combination in a single embodiment. Conversely, various aspects and characteristics of the invention, which are, for brevity, described in the context of a single embodiment, may also be provided separately or in any suitable sub-combination.

While the invention has been described in conjunction with specific embodiments and examples thereof, it is evident that many alternatives, modifications, and variations, will be apparent to those skilled in the art. Accordingly, it is intended to embrace all such alternatives, modifications, and variations, that fall within the scope of the appended claims.

All patents, patent applications, and publications, cited or referred to in this specification are herein incorporated in their entirety by reference into the specification, to the same extent as if each individual patent, patent application, or publication, was specifically and individually indicated to be incorporated herein by reference. In addition, citation or identification of any reference in this application shall not be construed as an admission that such reference is available as prior art to the present invention.

**Claims**

1.  A system for plotting an image on a thin material having variations in thickness, the system comprising:

    a plotter unit, suitable for plotting the image on a surface of the thin material;
    a control unit, suitable for controlling said plotter unit, for effecting said plotting;
    a thickness measuring device, suitable for measuring thickness of the thin material,
    wherein said control unit is operative to receive measured thickness values from said thickness measuring device, and to use said measured thickness values for adjusting said plotting of the image via said plotter unit, to compensate for the variations in thickness of the thin material.

2.  The system of claim 1, wherein said plotter unit is a photoplotter.

3.  The system of claim 2, wherein said photoplotter is one member of the group comprising a laser plotter, and an LED plotter

4.  The system of claim 1, wherein said plotter unit is of a type selected from the group consisting of a cylindrical (drum), and a flatbed.

5.  The system of claim 4, wherein said cylindrical (drum) type plotter unit is selected from the group consisting of an internal drum plotter unit, and an external drum plotter unit.

6.  The system of claim 1, wherein said control unit is operative to control said plotting of the image on said surface, by controlling at least one plotting parameter of said plotter unit.

7.  The system of claim 6, wherein said at least one plotting parameter is selected from the group consisting of a plotting scaling factor, a plotting timing factor, an image size parameter, and a combination thereof.

8.  The system of claim 7, wherein said plotting timing factor is usable by said plotter unit for said plotting according to a mode selected from the group consisting of:

    timing movement of said plotting subunit, timing movement of a thin material support element of said plotter unit, timing image formation of the image on the surface of the thin material, and a combination mode thereof.

9.  The system of claim 1, wherein said thickness measuring device is included within said plotter unit.

10. The system of claim 1, wherein said thickness measuring device includes a map generator operative to generate a map of the thin material, said map including thickness variation over the surface of the thin material.

11. The system of claim 1, wherein said thickness measuring device includes a type of sensor selected from the group consisting of: an optical based sensor for optically effecting said measuring thickness of the thin material, a mechanical based sensor for mechanically effecting said measuring thickness of the thin material, a capacitor based sensor for capacitively effecting said measuring thickness of the thin material, an ultrasonic sensor for ultrasonically measuring said thickness, and a combination sensor thereof.

12. The system of claim 1, wherein said thickness measuring device is operative for performing said generating measured thickness values for a plurality of sheets of more than one thin material on a per sheet basis.

13. The system of claim 1, wherein said control unit is operative to effect said compensating said plotting of the image, by adjusting at least one plotting parameter of said plotter unit.

14. The system of claim 13, wherein said at least one plotting parameter is selected from the group consisting of a plotting scaling factor, a plotting timing factor, an image size parameter, and a combination thereof.

15. The system of claim 14, wherein said plotting parameter is said plotting timing factor, used by said plotter unit for said plotting according to a mode selected from the group consisting of: timing movement of a plotting subunit of said plotter unit, timing movement of a thin material support element of said plotter unit, timing image formation of the image on the surface of the thin material, and a combination mode thereof.

16. The system of claim 1, wherein said plotter is configured for effecting said plotting the image on a thin material being a film.

17. The system of claim 16, wherein said film is a photosensitive film.

18. The system of claim 17, wherein said photosensitive film is a photosensitive silver halide film.

19. A system of claim 17, wherein said photosensitive film with the image plotted on said surface is a PCB mask.

20. A method for plotting an image on a thin material having variations in thickness, the method comprising:

measuring thickness of the thin material,
generating measured thickness values of the thin material;
controlling a plotter unit, to effect said plotting; and
plotting the image on a surface of the thin material, said controlling comprising using said measured thickness values for adjusting said plotting of the image, to compensate for the variations in thickness of the thin material.

21. The method of claim 20, wherein said controlling said plotter unit is effected by controlling at least one plotting parameter of said plotter unit.

22. The method of claim 21, wherein said at least one plotting parameter is selected from the group consisting of a plotting scaling factor, a plotting timing factor, an image size parameter, and a combination thereof.

23. The method of claim 22, wherein said plotting parameter is said plotting timing factor, used by said plotter unit for said plotting according to a mode selected from the group consisting of: timing movement of a plotting subunit of said plotter unit, timing movement of a thin material support element of said plotter unit, timing image formation of the image on the surface of the thin material, and a combination mode thereof.

24. The method of claim 20, wherein said measuring thickness of the thin material is effected by said thickness measuring device included within said plotter unit.

25. The method of claim 20, wherein said measuring thickness of the thin material includes generating a map of the thin material and including thickness variation of the thin material as a dimension in said map.

26. The method of claim 20, wherein said measuring thickness of the thin material is effected according to a type of sensing selected from the group consisting of:

optical based sensing for optically effecting said measuring thickness of the thin material,
mechanical based sensing for mechanically effecting said measuring thickness of the thin material, capacitive based sensing for capacitively effecting said measuring thickness of the
thin material, ultrasonically sensing, and a combination thereof.

27. The method of claim 20, wherein said measuring thickness is performed for a plurality of sheets of more than one thin material on a per sheet basis.

28. The method of claim 20, wherein said adjusting said plotting of the image is effected by adjusting at least one plotting parameter of said plotter unit.

29. The method of claim 28, wherein said at least one plotting parameter is selected from the group consisting of a plotting scaling factor, a plotting timing factor, an image size parameter, and a combination thereof.

30. The method of claim 29, wherein said plotting parameter is said plotting timing factor, used by said plotter unit for said plotting according to a mode selected from the group consisting of: timing movement of a plotting subunit of said plotter unit, timing movement of a thin material support element of said plotter unit, timing image formation of the image on the surface of the thin material, and a combination mode thereof.

31. The method of claim 20, wherein said plotting the image is effected for a thin material being a film.

**32.** The method of claim 31, wherein said film is a photosensitive film.

**33.** The method of claim 32, wherein said photosensitive film is a photosensitive silver halide film.

**34.** The method of claim 32, wherein said plotting is effected for forming a PCB mask.

Fig. 1 (prior art)

EP 1 872 956 A2

Fig. 2

EP 1 872 956 A2

Surface 48

Thin material 42

compensated
image plotting

thickness 44

thickness
measuring

Thin material support element 58

Plotting
subunit 56

Plotter
control
subunit 54

THICKNESS
MEASURING
DEVICE

52

PLOTTER UNIT 46

Control unit
50

**40**

Fig. 3

EP 1 872 956 A2

```
┌─────────────────────────────────────────────┐
│          Measure thickness of film           │
└─────────────────────────────────────────────┘
                        │
                        ▼
┌─────────────────────────────────────────────┐
│        Generate thickness values → Map       │
└─────────────────────────────────────────────┘
                        │
                        ▼
┌─────────────────────────────────────────────┐
│ Use values/map to adjust plotting, compensate for film │
│              thickness variations            │
└─────────────────────────────────────────────┘
                        │
                        ▼
┌─────────────────────────────────────────────┐
│            Plot with compensation            │
└─────────────────────────────────────────────┘
```

Fig. 4

Fig. 5

**80**

THICKNESS
MEASURING
DEVICE
52

thickness
measuring

XX

Plotting subunit
56

Plotter control subunit
56

Control unit
50

compensated
image plotting

thickness  88

Thin material
42

surface  89

(internal drum plotter)

PLOTTER UNIT 82

Drum  (thin material support
element)  84

Fig. 6

# 90

EP 1 872 956 A2

**(flatbed plotter)**

## PLOTTER UNIT 92

THICKNESS MEASURING DEVICE 52

Control unit 50

thickness measuring

surface 98

Plotting subunit 56

Plotter control subunit 54

Thin material 42

compensated image plotting

thickness 96

Thin material support element 94

Fig. 7

## PLOTTER UNIT 102

**Plotting subunit 56**

Plotting head moving
mechanism   112

Plotting head   114

**Plotter control subunit 54**

Plotting head moving
mechanism controller
108

Plotting head controller
110

Synchronization controller
106

compensated
image plotting

Thin material 42

Surface   116

Thickness
122

thickness
measuring

THICKNESS
MEASURING
DEVICE
52

Control unit
50

Thin material support element   104

Encoder reading head   120

Support element moving mechanism   118

**100**

Fig. 8

**130**

Plotting Head Moving Mechanism 112

Y-scale LUT 152

Film Thickness Information 154

Plotting Head 114

Thickness Measuring Device 52

Drum encoder 134 (50000 counts)

Thin material 42

Drum 132 rotated at ~ 900 rpm

Y synthesizer 144

PHMMC 108

X-scale LUT 150

Plotting head controller 110

120

PLL 140

X synthesizer 146

Data unit 156

Encoder pulses 136 (~0.75 MHz)

Encoder pulses with improved resolution 142 (~50 MHz)

Encoder index 138 (1pulse per rotation)

Raster Data 148

Fig. 9

EP 1 872 956 A2

**EP 1 872 956 A2**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5485082 A, Wisspeinter
- US 5629619 A, Mednikov
- US 20060202682 A, Mednikov
- US 5275465 A, Menard
- US 5421937 A, Menard